# EUROPEAN PATENT SPECIFICATION

(11) **EP 3 093 894 B1**
(45) Date of publication and mention of the grant of the patent: **05.08.2020**
(21) Application number: 16168741.3
(22) Date of filing: 09.05.2016
(51) Int. Cl.: H01L 33/52, H01L 33/58, H01L 33/00

(54) **A METHOD OF PRODUCING LIGHTING DEVICES AND CORRESPONDING DEVICE**
VERFAHREN ZUR HERSTELLUNG VON BELEUCHTUNGSEINRICHTUNGEN SOWIE ENTSPRECHENDE BELEUCHTUNGSEINRICHTUNG
PROCÉDÉ D'ASSEMBLAGE DE DISPOSITIFS D'ÉCLAIRAGE ET DISPOSITIF CORRESPONDANT

(30) Priority: 15.05.2015 IT UB20150765
(43) Date of publication of application: 16.11.2016
(73) Proprietor: OSRAM GmbH, 80807 München (DE); OSRAM S.P.A. - SOCIETA' RIUNITE OSRAM EDISON CLERICI, 20126 Milano (IT)
(72) Inventor: REISS, Martin, D-93161 Sinzing (DE); TREVISANELLO, Lorenzo Roberto, I-35031 Abano Terme (Padova) (IT); RIEGER, Thomas, D-93089 Aufhausen (DE)
(74) Representative: Bosotti, Luciano

(56) References cited:
- WO-A1-2015/036887
- DE-A1-102011 102 350

## Description

### Technical Field

The present description relates to lighting devices employing solid-state light radiation sources, such as LED sources, as light radiation sources.

### Technological Background

Various implementations of solid-state lighting devices comprise a support member implemented as an (optionally flexible) Printed Circuit Board (PCB), carrying solid-state light radiation sources. The substrate may have the shape of an elongate member adapted to be received in a channel-shaped (e.g. U-shaped) enclosure, the support member for the light radiation sources being located adjacent the core wall of the channel-shaped profile, so that the light radiation sources face towards the exterior of the channel-shaped profile. A potting mass may be arranged in the channel-shaped profile, so that the device is insulated from the outside. The potting mass may comprise a transparent part, facing towards the light radiation sources, and a diffusive layer extending at the mouth portion of the channel-shaped profile.

Such a lighting device is described e.g. in WO98/23896 A1. More specifically, the invention refers to a method according to the preamble of claim 1, which is known e.g. from WO2015/036887 A1. Also DE102011102350 A1 is of interest for the invention.

Such solutions may involve critical aspects due e.g. to the requirement of employing a channel-shaped profile, of gluing the support (PCB), of optionally using two potting processes in succession, the former for the transparent material and the latter for the diffusive layer.

### Object and Summary

The need is therefore felt for further improved solutions, adapted to overcome the previously outlined drawbacks. One or more embodiments aim at satisfying such a need.

According to one or more embodiments, such object is achieved thanks to a method having the features specifically set forth in the claims that follow.

The claims are an integral part of the technical teaching provided herein with reference to the embodiments.

One or more embodiments may provide one or more of the following advantages:
- the possibility of implementing a process with high parallelization, e.g. with single modules (for instance so-called "flex" modules) being cut out from a panel,
- the possibility of using only one gluing process,
- the possibility of performing only one cutting,
- the scalability of the achievable devices, e.g. as regards the extruded diffuser element, with the possibility of adjusting the thickness of the transparent layer and/or the concentration of the particles which determine the diffusive behaviour, the thickness of the diffusive layer being adaptable to the application and use requirements,
- the presence of an interposed compliant layer between diffuser element and light emission module (e.g. LED module).

### Brief Description of the Annexed Figures

One or more embodiments will now be described, by way of non-limiting example only, with reference to the annexed Figures, wherein:
- Figure 1 is a flow diagram exemplifying one or more embodiments,
- Figures 2 to 8 are ideal cross-section views showing subsequent steps of the flow diagram in Figure 1, and
- Figures 9 and 10, each comprising three parts respectively denoted as a), b) and c), exemplify scalability features of one or more embodiments.

It will be appreciated that, for better clarity of illustration, the parts visible in the Figures are not to be considered necessarily drawn to scale.

### Detailed Description

In the following description, numerous specific details are given to provide a thorough understanding of one or more exemplary embodiments. The embodiments may be practiced without one or several specific details, or with other methods, components, materials, etc. In other instances, well-known structures, materials or operations are not shown or described in detail to avoid obscuring various aspects of the embodiments. Reference throughout this specification to "one embodiment" or "an embodiment" means that a particular feature, structure, or characteristic described in connection with the embodiment is included in at least one embodiment. Thus, the possible appearances of the phrases "in one embodiment" or "in an embodiment" in various places throughout this specification are not necessarily all referring to the same embodiment.

The headings provided herein are for convenience only, and therefore do not interpret the extent of protection or scope of the embodiments.

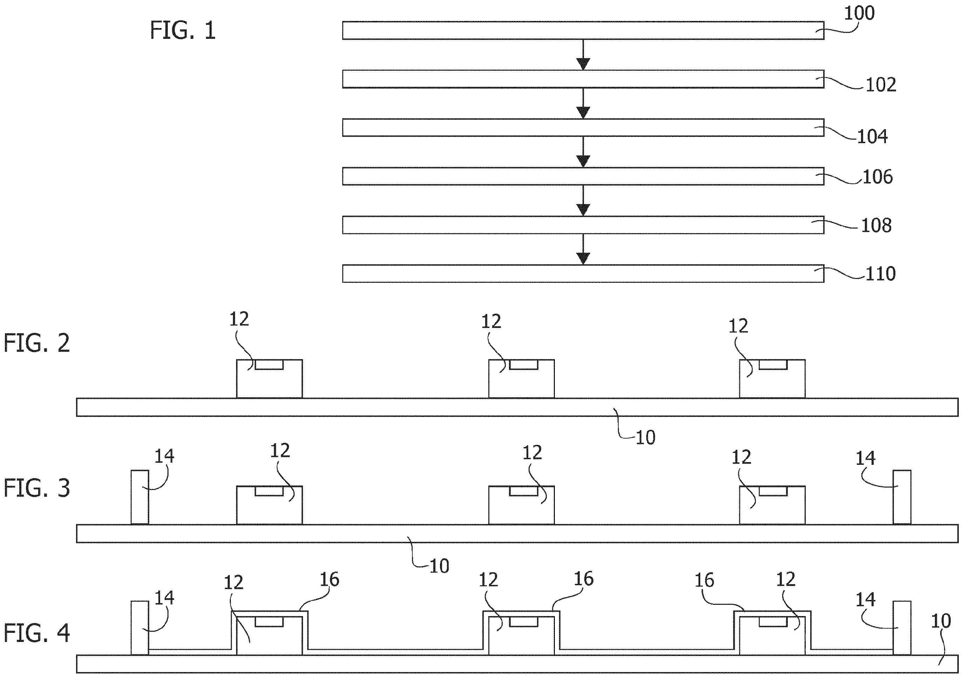

Figures 2 to 8 show subsequent steps for producing a solid-state lighting device according to the sequence exemplified in the flow diagram of Figure 1.

One or more embodiments involve the use of a substrate 10 substantially comprised of a Printed Circuit Board (PCB) whereon there are arranged electrically-powered light radiation sources 12. The sources are solid-state light radiation sources, such as LED light radiation sources.

The possibility of mounting such light radiation sources on PCB supports is well known and widespread in the art, also as regards providing support member 10 with electrically-conductive lines (not visible in the

Figures). Such lines allow for the transfer of power supply to light radiation sources 12. The possibility is also known to provide conductive lines adapted to convey towards sources 12 electrical control signals, and/or to obtain from sources 12 signals such as feedback signals, which may be used e.g. for supporting the control or protection of light radiation sources 12. This can be achieved (also as regards the choice of the materials) according to criteria known in the art, which makes it unnecessary to provide a more detailed description herein.

With reference to the present description, support member 10 shown in Figure 2 to 7 is assumed to comprise a plate (which may be square or rectangular, but without limiting the possible embodiments) with the light radiation sources 12 being arranged on support member 10 along an array (e.g. a matrix array) consisting in linear arrays in sequence. Each source 12 visible in Figure 2 may therefore be considered as representative of such a linear array.

For example, taking into account an amount that is deliberately low in order to facilitate the understanding of the present exemplary description, Figures 2 to 7 may be considered as referring to a square or rectangular support member (PCB) 10, on which there are mounted e.g. three parallel rows of light radiation sources 12. Each of the three sources 12 visible in the Figures exemplifies therefore one such row, in a foreshortened view in the general cross-section illustration of support 10, corresponding to the views of Figures 2 to 7.

The provision of a support 10 which mounts sources 12 as exemplified in Figure 2 may be considered as corresponding to the starting step 100 of the flow diagram in Figure 1. In this respect it must be remarked that support 10 may be either flexible or stiff.

Step 102 of the flow diagram in Figure 1 corresponds to a step, wherein a containment formation 14 is either applied or formed on support member 10, e.g. a frame adapted to form, around the array of light radiation sources 12, a sort of boundary or dam. This has the purpose to avoid the leakage of a layer of adhesive material 16 adapted to be dispensed or poured (in the step denoted as 104 in the flow diagram of Figure 1) on substrate 10 and on sources 12, according to what is schematically shown in Figure 4.

In one or more embodiments, layer 16 may comprise a compliant adhesive material.

In one or more embodiments the adhesive material may be a thixotropic viscous adhesive, such as an adhesive comprising silicone, polyurethane (PU) or polyurethane-polyamide (PU-PA).

In one or more embodiments, adhesive layer 16 may exhibit a viscosity in the range of 100,000 - 500,000 mPa.s, and/or a thixotropic index in the range of 2 to 4.

The adhesive 16 may be dispensed according to known ways, e.g. by spraying or simply by pouring, possible side leakages of adhesive 16 being contrasted by the dam-effect offered by containment formation 14.

In order to obtain such a containment formation, a highly viscous material may be used (e.g. a silicone- or polyurethane-based material). In one or more embodiments, if support 10 is flexible, containment formation 14 may simply consist of the peripheral edges of support 10, which are folded so as to form a dam structure around light radiation sources 12.

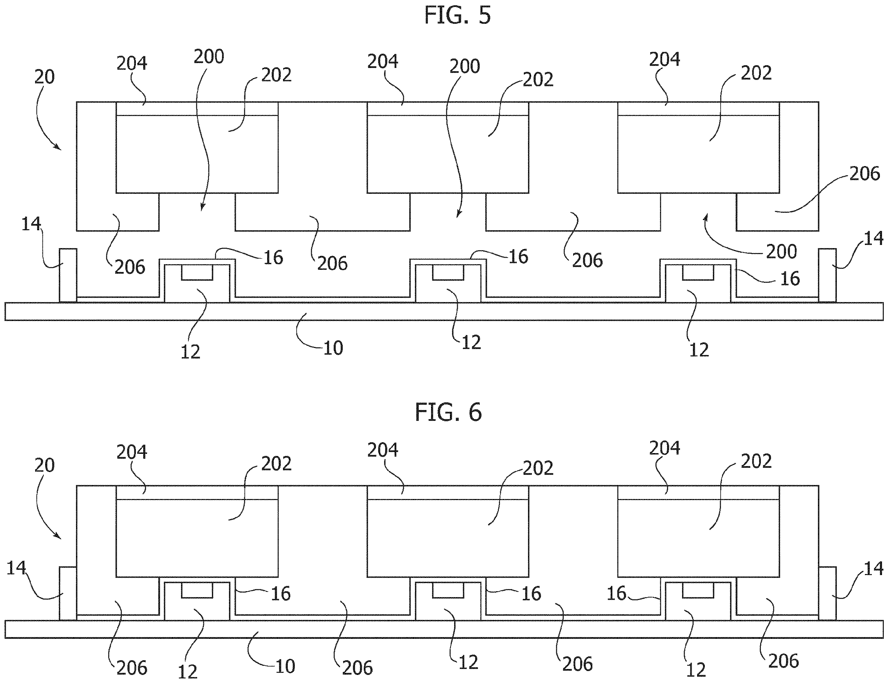

Once the structure exemplified in Figure 4 has been achieved in the step exemplified by block 104 of the diagram in Figure 1, in the sequence exemplified in Figures 5 and 6 (corresponding to step 106 of the flow diagram in Figure 1) in one or more embodiments a light propagating element, such as a diffuser element 20, may be applied on such a structure.

The diffuser element 20 may be a pre-manufactured component, obtained e.g. via an extrusion process, and it can be applied onto support 10 and onto sources 12 via a form fit.

As exemplified in Figure 5, diffuser element 20 may comprise a plate of a certain thickness having, on the side which is destined to face light radiation sources 12, cavities or wells 200 which are arranged and sized to receive light radiation sources 12 therewithin.

In one or more embodiments, diffuser element 20 may be implemented (using either different materials or one single material, e.g. silicone) so that it exhibits areas having different properties as regards the propagation of the light radiation emitted by source 12.

E.g., in the vicinity of each well or cavity 200 there may be provided (according to a general stripe-shaped configuration, since light radiation sources 12 form on support member 10 a bi-dimensional array) a light permeable (i.e. transparent) portion 202, having a light diffusive portion 204 (again in the shape of a stripe) thereon.

In one or more embodiments, portions or stripes 202, 204 may then be separated by further insulating stripes 206 of a substantially light impermeable (e.g. white opaque) material.

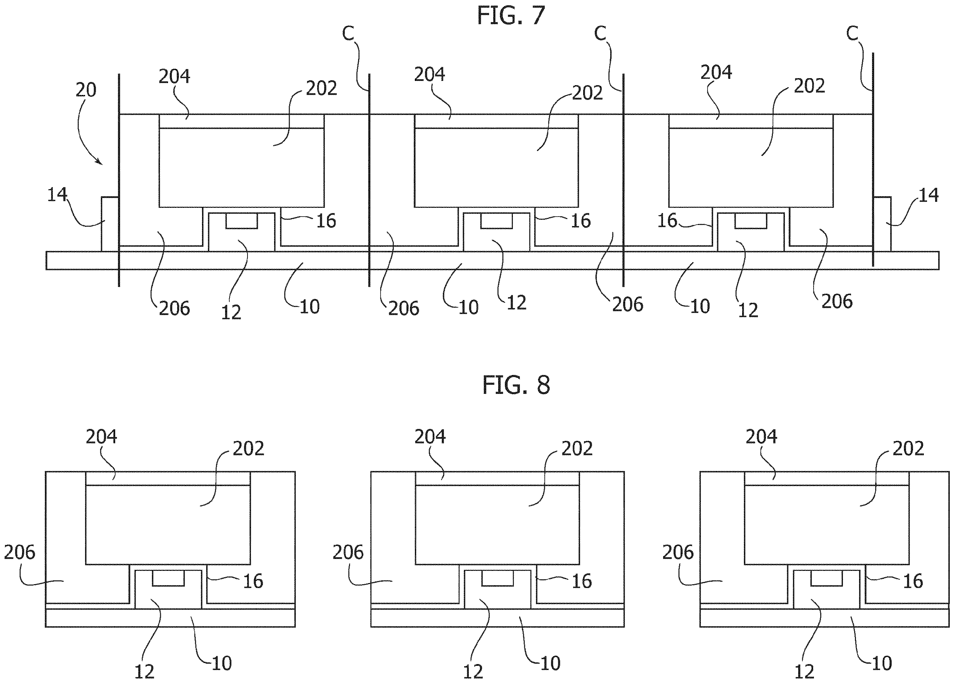

In this way, the light radiation emitted by sources 12 propagates through the light-permeable portion 202 as far as diffusive layer 204, and then diffuses outside the structure. Moreover, propagation along the plane of support 10 (in a horizontal direction, as viewed in Figures 6 and 7) may be inhibited by insulating stripes 206. The latter tend to reflect the light radiation impinging upon them towards portions 202, 204, so that light radiation is emitted from the front side (above in the Figures) of the presently exemplified structure.

A similar return effect towards the transparent and the diffusive portions 202, 204 may also be performed by the side appendixes or flaps of insulating stripes 206 which, as can be seen in the Figures, advance towards light radiation sources 12 infiltrating below transparent portions 202.

Once the arrangement shown in Figure 6 has been achieved, i.e. once diffuser element 20 has been coupled to support 10 whereon light radiation sources 12 are mounted, in a subsequent step 108 of the flow diagram in Figure 1 a curing 108 of adhesive layer 16 may be carried out.

Diffuser element 20 is therefore sealingly coupled to substrate 10 so as to form a protection enclosure, adapted to impart, to the structure thus implemented (and especially to sources 12) a sealing effect from humidity, electrostatic discharge (ESD) and the possible penetration of particles or fluids, while also achieving a protection from mechanical stresses.

In one or more embodiments, in a subsequent step denoted as 110 in the flow diagram of Figure 1 and schematically shown in Figure 7, the previously obtained structure (which, as already stated, may be substantially considered as a sort of matrix array) is subjected to cutting as schematically shown by lines C in Figure 7, i.e. the structure is cut intermediate adjacent stripes 202, 204 (and optionally, e.g. in the case of the provision of containment formation 14, along the lateral edges of the structure). Cutting may be performed e.g. by any tool adapted to the purpose, for instance with a cutter as used for the manufacturing of ICs.

The achievable result is exemplified in Figure 8: a plurality of ribbon-shaped lighting modules are obtained (e.g. three modules, in the presently considered example, which is deliberately simplified for illustration purposes). The modules may be so-called "flex" modules. Each module comprises a ribbon-shaped support element 100 carrying a (e.g. linear) array of light radiation sources 12, a respective diffuser element being sealingly applied by gluing through adhesive 16. Such a diffuser element comprises a light-permeable stripe 202, aligned with the array of sources 12, diffusive layer 204 being superimposed thereon. Two substantially light-impermeable portions 206 form, on the sides of each element, a sort of channel-shaped reflector, adapted to favour the propagation of the light radiation emitted by sources 12 towards the exit surface, where the diffusive layer 204 is provided.

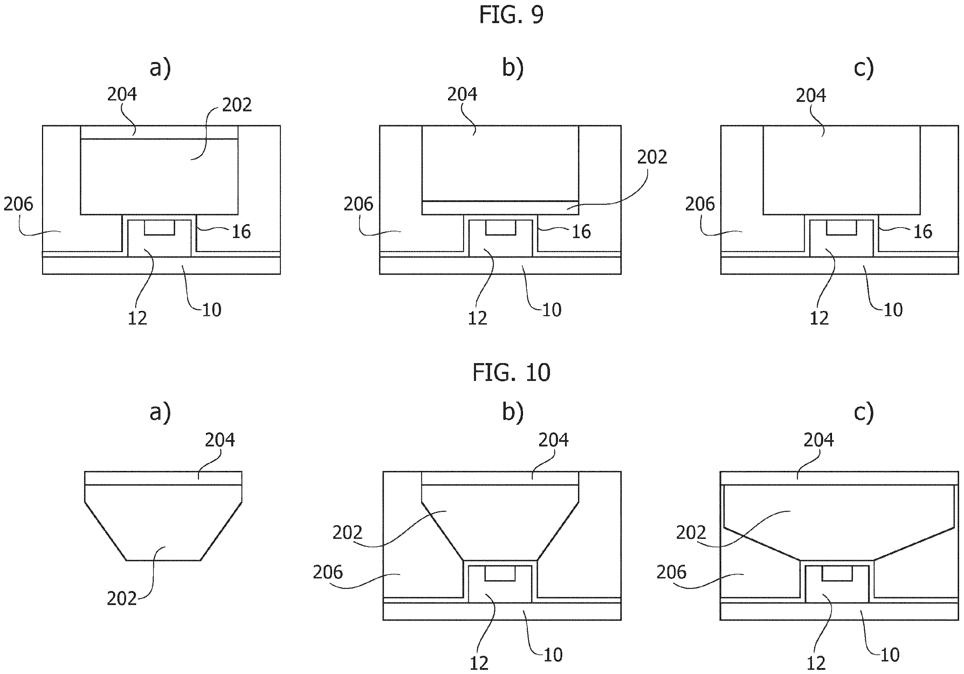

Figures 9 and 10, each comprising three portions respectively denoted as a), b) and c), highlight the scalability features of the presently discussed solution as regards e.g. the relative thickness of layers 202, 204 and/or their configuration, e.g. with respect to layer 202.

Portions a), b) and c) in Figure 9 highlight the possibility, in one or more embodiments, of:
- providing a diffusive layer 204 having a lower thickness or height than layer 202 (portion a)),
- providing a diffusive layer 204 having a higher thickness / height than layer 202 (portion b)),
- virtually eliminating light permeable or transparent layer 202, so that, after traversing adhesive layer 16, which in the present case is assumed to be light permeable itself, too, the radiation emitted by sources 12 only traverses one diffusive layer, i.e. layer 204, before propagating towards the outside of lighting device.

In one or more embodiments, it would of course be possible to proceed in a complementary way, i.e. by having the light radiation emitted by sources 12 traverse only one light-permeable or transparent layer, i.e. layer 202, without the provision of diffusive layer 204.

Portion a) in Figure 10 exemplifies the possibility of imparting, e.g. to the stripe of layer 202, a sort of convex-bottomed shape, so that layer 202 forms a sort of bowl (so to say pseudo-parabolic) reflector, being therefore adapted to favour the propagation of the light radiation emitted by sources 12 towards the front surface of the lighting device. The features may be controlled on the basis of the application and use needs through the transverse profile imparted to the stripe of layer 202, i.e. by achieving a bowl reflector structure having a wider or narrower opening angle (in this respect, compare portions b) and c) of Figure 10).

In order to achieve the curing or reticulation of adhesive 16 various processes may be resorted to which may consist in either room temperature vulcanization or hot reticulation processes, which may be considered as known in the art and therefore do not require a detailed description herein.

As a reference, and without even indirectly limiting the embodiments, diffuser element 20 may be e.g. 1-2 mm thick and, referring to the individual lighting devices as shown in Figure 8, may have "sides" 206 of a substantially light-impermeable (e.g. white) material, which may have a similar thickness as measured at the front face (above in the Figures) of the individual lighting device.

As for the possibility of implementing portions 202, 204, 206 with different features of light radiation propagation, in one or more embodiments it is possible to resort either to different materials or to substantially identical materials (e.g. silicone) and to obtain the different light propagation features by varying the percentage of a filler (e.g. Al₂O₃) contained therein.

According to criteria known in themselves, e.g. a silicone-based material adapted to constitute transparent (or "clear") portion 202 if substantially free from fillers, may be used to form diffusive layer 204 if it contains a first percent amount of particulate material such as alumina. Increasing the amount of fillers to higher values, e.g. by employing the same fillers, enables to form portion 206 which is substantially impermeable to light radiation.

Of course, without prejudice to the basic principles, the details and the embodiments may vary, even appreciably, with respect to what has been described herein by way of non-limiting example only, without departing from the extent of protection.

Said extent of protection is defined by the annexed claims.

## Claims

1. A method of producing lighting devices, the method including:
- providing a support substrate (10) with electrically powered solid-state light radiation sources (12) in a plurality of linear arrays arranged side-by-side;
- sealingly coupling to said support substrate (10) a light-propagating element (20) having cavities (200) for receiving therein said solid-state light radiation sources (12), and
- cutting (C) said support substrate (10) with said light-propagating element (20) sealingly coupled therewith intermediate said linear arrays of said solid-state light radiation sources (12) to produce a plurality of linear lighting devices,
- sealingly coupling said light-propagating element (20) to said support substrate (10) by means of an adhesive (16),
**characterized in that** the method includes:
- dispensing said adhesive (16) onto said support substrate (10) and onto said solid-state light radiation sources (12), and
- providing a peripheral containment formation (14) to confine said adhesive (16) dispensed onto said support substrate (10).

2. The method of claim 1, wherein said adhesive (16) includes a compliant adhesive (16).

3. The method of claim 1 or claim 2, wherein said adhesive (16) is a viscous thixotropic adhesive.

4. The method of claims 1 to 3, wherein said adhesive (16) exhibits at least one of the following features:
- a viscosity between 100.000 and 500.000 mPa.s, and
- a thixotropic index between 2 and 4.

5. The method of claim 1, including providing said peripheral containment formation (14),
- by applying it onto said support substrate (10), or
- by peripherally bending said support substrate (10) .

6. The method of any of the previous claims, including providing at said cavities (200) in said light propagating element (20) at least one of:
- a light permeable portion (202) to be traversed by light radiation from the source (12) received in said cavity (200),
- a light diffusive portion (204) to be traversed by light radiation from the source (12) received in said cavity (200),
- a light impermeable portion (206) to confine laterally light radiation from the source (12) received in said cavity (200).

7. The method of claim 6, including providing said light-permeable portion (202), said light diffusive portion (204) and said light impermeable portion (206) of one material, preferably a silicone-based material, with different filler levels.

8. A lighting device produced with a method of any of claims 1 to 7, wherein said electrically powered solid-state light sources (12) are LED sources.

## Patentansprüche

1. Verfahren zum Herstellen von Beleuchtungsvorrichtungen, wobei das Verfahren umfasst:
- Bereitstellen eines Trägersubstrats (10) mit elektrisch betriebenen Festkörper-Lichtstrahlungsquellen (12) in einer Vielzahl von linearen Anordnungen, die nebeneinander angeordnet sind;
- abdichtendes Koppeln an das Trägersubstrat (10) eines lichtausbreitenden Elements (20) mit Kavitäten (200) zum Empfangen der Festkörper-Lichtstrahlungsquellen (12), und
- Schneiden (C) des Trägersubstrats (10) mit dem lichtausbreitenden Element (20), das dadurch zwischen den linearen Anordnungen der Festkörper-Lichtstrahlungsquellen (12) abdichtend gekoppelt ist, um eine Vielzahl von linearen Beleuchtungsvorrichtungen herzustellen,
- abdichtendes Koppeln des lichtausbreitenden Elements (20) mit dem Trägersubstrat (10) mittels eines Klebemittels (16),
**dadurch gekennzeichnet, dass** das Verfahren umfasst:
- Verteilen des Klebemittels (16) auf das Trägersubstrat (10) und auf die Festkörper-Lichtstrahlungsquellen (12), und
- Bereitstellen einer peripheren Einschlussbildung (14), um das Klebemittel (16), das auf dem Trägersubstrat (10) verteilt ist, einzuschließen.

2. Verfahren nach Anspruch 1, wobei das Klebemittel (16) ein nachgiebiges Klebemittel (16) beinhaltet.

3. Verfahren nach Anspruch 1 oder 2, wobei das Klebemittel (16) ein viskoses thixotropes Klebemittel ist.

4. Verfahren nach den Ansprüchen 1 bis 3, wobei das Klebemittel (16) mindestens eines der folgenden Merkmale aufweist:
- eine Viskosität zwischen 100.000 und 500.000 mPa.s, und
- einen thixotropen Index zwischen 2 und 4.

5. Verfahren nach Anspruch 1, beinhaltend Bereitstellen der peripheren Einschlussbildung (14),
- durch Anwenden auf das Trägersubstrat (10),
oder
- durch peripheres Biegen des Trägersubstrats (10).

6. Verfahren nach einem der vorhergehenden Ansprüche, beinhaltend Bereitstellen an den Kavitäten (200) in dem lichtausbreitenden Element (20) von mindestens einem von:
- einen lichtdurchlässigen Abschnitt (202), der von der Lichtstrahlung von der Quelle (12) durchquert wird, die in der Kavität (200) empfangen wird,
- einen lichtstreuenden Abschnitt (204), der von der Lichtstrahlung von der Quelle (12) durchquert wird, die in der Kavität (200) empfangen wird,
- einen lichtundurchlässigen Abschnitt (206), um seitliche Lichtstrahlung von der Quelle (12) einzuschließen, die in der Kavität (200) empfangen wird.

7. Verfahren nach Anspruch 6, beinhaltend das Bereitstellen des lichtdurchlässigen Abschnitts (202), des lichtstreuenden Abschnitts (204) und des lichtundurchlässigen Abschnitts (206) aus einem Material, vorzugsweise einem Material auf Silikonbasis, mit unterschiedlichen Füllgraden.

8. Beleuchtungsvorrichtung, hergestellt nach einem Verfahren nach einem der Ansprüche 1 bis 7, wobei die elektrisch betriebenen Festkörper-Lichtquellen (12) LED-Quellen sind.

## Revendications

1. Un procédé de production de dispositifs d'éclairage, le procédé comprenant :
- l'obtention d'un substrat support (10) avec des sources de rayonnement lumineux à semi-conducteurs alimentées électriquement (12) selon une pluralité de réseaux linéaires disposés côte-à-côte ;
- le couplage étanche audit substrat support (10) d'un élément propagateur de lumière (20) avec des cavités (200) destinées à recevoir dedans lesdites sources de rayonnement lumineux à semi-conducteurs (12), et
- la découpe (C) dudit substrat support (10) avec ledit élément propagateur de lumière (20) couplé de manière étanche à celui-ci entre lesdits réseaux linéaires desdites sources de rayonnement lumineux à semi-conducteurs (12) pour produire une pluralité de dispositifs d'éclairage linéaires,
- le couplage étanche dudit élément propagateur de lumière (20) audit substrat support (10) au moyen d'un adhésif (16),
**caractérisé en ce que** le procédé comprend :
- l'application dudit adhésif (16) sur ledit substrat support (10) et sur lesdites sources de rayonnement lumineux à semi-conducteurs (12), et
- l'obtention d'une formation de rétention périphérique (14) pour confiner ledit adhésif (16) appliqué sur ledit substrat support (10).

2. Le procédé de la revendication 1, dans lequel ledit adhésif (16) comprend un adhésif conformable (16).

3. Le procédé de la revendication 1 ou de la revendication 2, dans lequel ledit adhésif (16) est un adhésif thixotrope visqueux.

4. Le procédé des revendications 1 à 3, dans lequel ledit adhésif (16) présente au moins l'une des caractéristiques suivantes :
- une viscosité comprise entre 100 000 et 500 000 mPa.s, et
- un indice thixotropique compris entre 2 et 4.

5. Le procédé de la revendication 1, comprenant l'obtention de ladite formation de rétention périphérique (14)
- par application de celle-ci sur ledit substrat support (10), ou
- par courbure périphérique dudit substrat support (10).

6. Le procédé de l'une des revendications précédentes, comprenant l'obtention au niveau desdites cavités (200) dans ledit élément propagateur de lumière (20) d'au moins l'une d'entre :
- une partie perméable à la lumière (202) destinée à être traversée par le rayonnement lumineux reçu dans ladite cavité (200) en provenance de la source (12),
- une partie de diffusion de lumière (204) destinée à être traversée par le rayonnement lumineux reçu dans ladite cavité (200) en provenance de la source (12),
- une partie imperméable à la lumière (206) destinée à confiner latéralement le rayonnement lumineux reçu dans ladite cavité (200) en provenance de la source (12) .

7. Le procédé de la revendication 6, comprenant l'obtention de ladite partie perméable à la lumière (202), de ladite partie de diffusion de lumière (204) et de ladite partie imperméable à la lumière (206) à partir d'un seul matériau, de préférence un matériau à base de silicone, avec des niveaux de charge différents.

8. Un dispositif d'éclairage produit avec un procédé selon l'une des revendications 1 à 7, dans lequel lesdites sources de lumière à semi-conducteurs alimentées électriquement (12) sont des sources LED.
